# EUROPEAN PATENT APPLICATION

(11) **EP 4 661 080 A1**
(43) Date of publication of application: **10.12.2025**
(21) Application number: 25180191.6
(22) Date of filing: 02.06.2025
(51) Int. Cl.: H01L 23/538, H01L 23/13, H01L 23/525, H01L 23/62, H01L 21/48, H01L 23/373, H01L 25/07

(54) **POWER MODULE AND METHOD FOR OPERATING SAME**

(30) Priority: 05.06.2024 GB 202407966
(71) Applicant: Rolls-Royce Deutschland Ltd & Co KG, 15827 Blankenfelde-Mahlow (DE)
(72) Inventor: GAJANAYAKE, Chandana, 15827 Blankenfelde-Mahlow (DE); WANG, Shuai, 15827 Blankenfelde-Mahlow (DE); MOHAMED HALICK, Mohamed Sathik, 15827 Blankenfelde-Mahlow (DE); HO, Anh Vu, 15827 Blankenfelde-Mahlow (DE)

(57) **Abstract**

A power module (2) has: an upper side (21) and a lower side (22), a plurality of electrical contact pads (42) on the upper side (21), an insulating layer (231), an upper metallization layer (232) disposed on the insulating layer (231), and a semiconductor switch (24) having upper electrical contacts (241, 242) and a lower electrical contact (243), wherein the semiconductor switch (42) is arranged on the upper metallisation layer (232), wherein the lower electrical contact (243) is electrically connected to the upper metallization layer (232), wherein the plurality of electrical contact pads (42) comprises a first contact pad (425) which is electrically connected via first vias (421) to the upper metallization layer (232) and second and third contact pads (426, 427) which are connected to the upper electrical contacts (241, 242) of the semiconductor switch (24), and wherein the upper metallization layer (232) is configured to provide a conduction path (6) between the first vias (421) and the lower electrical contact (243) of the semiconductor switch (24). It is further provided that the upper metallisation layer (232) is structured to form multiple separate segments (611-616; 621-627; 631-637; 641-647; 651-653), wherein each segment (611-616; 621-627; 631-637; 641-647; 651-653) is configured to form part of the conduction path (6) between the first vias (421) and the lower electrical contact (243) of the semiconductor switch (24).

## Description

### FIELD

The present disclosure relates to a power module and to a method for operating such power module.

### BACKGROUND

With increased penetration of electrical systems and the progression towards full electric and hybrid propulsion systems, the use of energy storage systems and DC power distribution has gained increased use. Multiple loads and sources may be connected to a DC distribution system such as a hybrid propulsion system. In such systems, power converters such as inverters, rectifiers and DC/DC converters are needed for interfacing electrical propulsion motors, turbo generators, fuel cells and battery energy storage systems. Further, in such systems, adequate DC protection devices are required. Due to the fact that SSPCs (Solid State Power Controllers, also referred to a Solid State Circuit Breakers) show a fast response time, eliminate arcing during turn-off, and have a high reliability, SSPCs are preferred over electro-mechanical switches.

All such devices include switching units, wherein it is known to connect in a switching unit several semiconductor switches such as MOSFETs in parallel. Each of the semiconductor switches may be provided in the form of a packaged power module that is connectable to a printed circuit board. When a number of parallel semiconductor switches is arranged in parallel, there is a risk that failure of one or several semiconductor switches leads to failure or shutdown of the complete switching unit. Therefore, there is a need to be able to service the semiconductor switches and remove a faulty semiconductor switch.

There is a need to provide a power module that allows to be serviced in an efficient manner, and to provide for a method of operating such power module.

### SUMMARY

In a first aspect a power module is provided. The power module comprises an upper side and a lower side and a plurality of electrical contact pads on the upper side, wherein the contact pads are configured to electrically contact corresponding contact pads of a printed circuit board. The power module further comprises an insulating layer, an upper metallization layer disposed on the insulating layer, and a semiconductor switch having upper electrical contacts and a lower electrical contact, wherein the semiconductor switch is arranged on the upper metallisation layer, and wherein the lower electrical contact is electrically connected to the upper metallization layer. It is further provided that the plurality of electrical contact pads comprises a first contact pad which is electrically connected via first vias to the upper metallization layer and second and third contact pads which are connected to the upper electrical contacts of the semiconductor switch. The upper metallization layer is configured to provide a conduction path between the first vias and the at least one lower electrical contact of the semiconductor switch.

It is further provided that the upper metallisation layer is structured to form multiple separate segments, wherein each segment is configured to form part of the conduction path between the first vias and the lower electrical contact of the semiconductor switch component.

Aspects of the present invention are thus based on the idea to provide a conduction path by the metallization layer that is not uniform, but provided in a segmented manner by separate segments. The conduction path is thus broken into smaller parts. An advantage associated with such solution lies in that a current guided through the conduction path can be focused on one or several of the separate segments, thereby increasing the current through one or several of the segments at a specific time. This allows to facilitate controlled burning of the semiconductor switch by means of controlled short-circuiting to facilitate the provision of an open circuit in the failed semiconductor switch.

It is pointed out that within the meaning of the present disclosure that side of the power module which is directed towards a printed circuit board is always considered to be the top side, irrespective of the actual 3D position of power module.

In some embodiments, each of the different segments of the upper metallization layer is configured to conduct a pulsed current of a different specific frequency or frequency range. In other words, each segment is configured to guide current of a specific frequency or frequency range, wherein each segment is associated with a specific frequency or frequency range (such that different segments guide current of different frequencies or frequency ranges). Thereby, by providing a pulsed current of a specific frequency or frequency range, it is possible to guide most of the current to the segment which is configured to guide current of that specific frequency or frequency range. By concentrating the pulsed current to one of the segments, it is facilitated to burn that segment by increased current flow. Subsequently, a pulsed current of a different specific frequency or frequency range may be provided, thereby guiding most of the current to another of the segments, thereby facilitating to burn that segment. In this manner, by sweeping through several frequencies or frequency ranges of the pulsed current, all of the segments of the metallization layer can be burnt sequentially (step-by-step) with the result that the complete conduction path is turned into an open circuit. The faulty semiconductor switch can be efficiently removed in this manner.

The physics behind this embodiment lies in that current, depending on its frequency, is automatically spread to the segment which has physical boundaries which are suitable to guide current of that frequency. Accordingly, by choosing a specific frequency or frequency range, it can be achieved that a short-circuit current through a faulty, short-circuited semiconductor switch is directed to a specific one of the segments, thereby facilitating controlled burning of that segment, and by going through different frequencies or frequency ranges, controlled burning of all segments and thus of the semiconductor switch can be achieved effectively.

In some embodiments, the multiple segments are provided in the form of multiple strips of different size and/or form, wherein the multiple separated strips form the conduction path. For example, the multiple strips may be formed by slits provided in the upper metallization layer, thereby allowing in a simple manner to provide strips of different size and/or form.

For example, the width of the strips may vary. In embodiment, the strips comprise first and second edge-located strips, wherein the width of the strips increases from the first edge-located strip to the second edge-located strip. In another embodiment, the width of the strips may increase from the first and second edge-located strips to a middle strip arranged between the first and second edge-located strips (and thus towards the center). For example, the width of the strips/segments changes linearly or exponentially.

The strips may be formed as straight rectangular strips, wherein different strips have different width. In other embodiments, the strips are not straight and have other forms. For example, the strips may be formed as zigzag formed segments or as wavy segments. In such case as well, the width of the strips may vary.

In embodiments, the multiple segments are provided in the form of multiple stacked conductive layers of different thickness, wherein non-conductive layers are arranged between the conductive layers, and wherein the multiple conductive layers of different thickness form the conduction path. For example, the multiple conductive layers may comprise an upper layer and a lower layer, wherein the thickness of the conductive layers is increasing from the upper layer to the lower layer or vice versa, or wherein the thickness is increased towards a middle layer. The multiple conductive layers may be connected through plated through holes, wherein a pulsed current of a specific frequency or frequency range automatically spreads into the conductive layer which has a dimensions in accordance with that specific frequency or frequency range.

In such embodiments, the non-conductive layers may be formed as FR4 or ceramic layers to provide for a better insulation quality.

In some embodiments, the module comprises electrical contacts as follows: the first contact pad is a drain pad configured to provide a drain voltage to the semiconductor switch; the second contact pad is a source pad configured to provide a source voltage to the semiconductor switch; the third contact pad is a gate pad configured to provide a gate voltage to the semiconductor switch; wherein the semiconductor switch comprises as upper electrical contacts a source contact and a gate contact; and wherein the semiconductor switch comprises as a lower electrical contact a drain contact.

Accordingly, in this embodiment, it is the drain contact which receives current through the multiple separate segments into which the conduction path is broken.

In some embodiments, the multiple segments are configured to connect an area of the upper metallization layer connected to the first vias and an area of the upper metallization layer connected to the lower electrical drain contact. Current is thus conducted from the first contact pad through the first vias and further through the multiple separate segments of the upper metallization layer to the drain contact of the semiconductor switch.

In some embodiments, the power module comprises a ceramic circuit carrier, wherein the insulating layer is an insulating ceramic layer of the ceramic circuit carrier and the upper metallization layer is disposed on the ceramic layer. Such embodiment provides high electrical insulation towards a heatsink connected to the bottom side of the power module.

As mentioned, the power module may be configured to be thermally connected at its lower side to a heat sink, thereby allowing efficient cooling of the subject switch. A thermal interface material may be located between the lower side of the power module and the heatsink to avoid the presence of a gap between the power module and the heatsink.

In some embodiments, a vent is integrated into the power module, wherein the vent is configured to improve the removal of thermal energy from the power module in case of a short-circuit of the semiconductor switch, thereby reducing the risk that such thermal heat harms neighboring power modules.

In a second aspect a method of operating a power module that is in accordance with the present invention is provided. The method comprises the steps of: passing a first pulsed current flow of a first frequency or frequency range through the semiconductor switch, wherein a first of the multiple segments is configured to conduct the first pulsed current flow; and passing a second pulsed current flow of a second frequency or frequency range through the semiconductor switch, wherein a second of the multiple segments is configured to conduct the second pulsed current flow.

Accordingly, the semiconductor switch guides current with different frequencies or frequency ranges. Depending on the frequency or frequency range, different of the multiple segments conduct the pulsed current, thereby allowing the specific burning of different of the multiple segments through a high current such as a short-circuited current: the current is concentrated at different of the multiple segments in accordance with the specific frequency or frequency range of the control signal that is applied to the control terminal.

In some embodiments, the method is continued by passing a third, fourth, ..., Nth pulsed current flow of a third, fourth, ..., Nth frequency or frequency range through the semiconductor switch, until each of the multiple segments has conducted one of first to Nth pulsed current flows. At the same time, each of the multiple segments is configured to burn when conducting a current in accordance with the corresponding pulsed current flow of one of the respective first to Nth frequency or frequency range. Accordingly, the multiple segments are configured to burn one after the other when the pulsed current sweeps through the first to Nth frequency or frequency range, thereby allowing a controlled burning of a short-circuited semiconductor switch in an effective manner.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### BRIEF DESCRIPTION OF THE DRAWINGS

The invention will be explained in more detail on the basis of exemplary embodiments with reference to the accompanying drawings in which:
FIG. 1 is a schematic top view onto an embodiment of a power module, wherein the power module comprises a semiconductor switch arranged on an upper metallization layer, wherein the metallization layer forms multiple separate straight segments which serve to provide a current to a bottom drain contact of the semiconductor switch, and wherein the width of the separate segments increases towards a side segment;
FIG. 2 is a schematic top view onto an embodiment of a power module similar to the power module of FIG. 1, wherein the width of the separate segments increases towards a middle segment;
FIG. 2A shows schematically separate segments with different width, wherein the width of the segments follows a linear or exponential pattern;
FIG. 3 is a schematic top view onto an embodiment of a power module similar to the power module of FIG. 1, wherein the multiple separate segments are formed with a zigzag design, and wherein the width of the separate segments increases towards a side segment;
FIG. 4 is a schematic top view onto an embodiment of a power module similar to the power module of FIG. 1, wherein the multiple separate segments are formed with a zigzag design, and wherein the width of the separate segments increases towards a middle segment;
FIG. 5 is a flowchart of a method for operating a power module;
FIG. 6 shows another embodiment of a conduction path that is broken into multiple separate segments, wherein the multiple separate segments are formed by conductive layers of different thickness which are stacked;
FIG. 7 shows the general structure of a power module that comprises a semiconductor switch arranged on an upper metallization layer, wherein the upper metallization layer is connected by means of vias with an upper contact pad of the power module; and
FIG. 8 is an embodiment of a DC power system that implements an SSPC, wherein the SSPC includes first and second switching units which each comprise a plurality of semiconductor switches arranged in parallel, and wherein further an auxiliary switching unit is provided that allows to guide a short-circuit current through a faulty semiconductor switch to burn and remove the faulty semiconductor switch.

### DETAILED DESCRIPTION

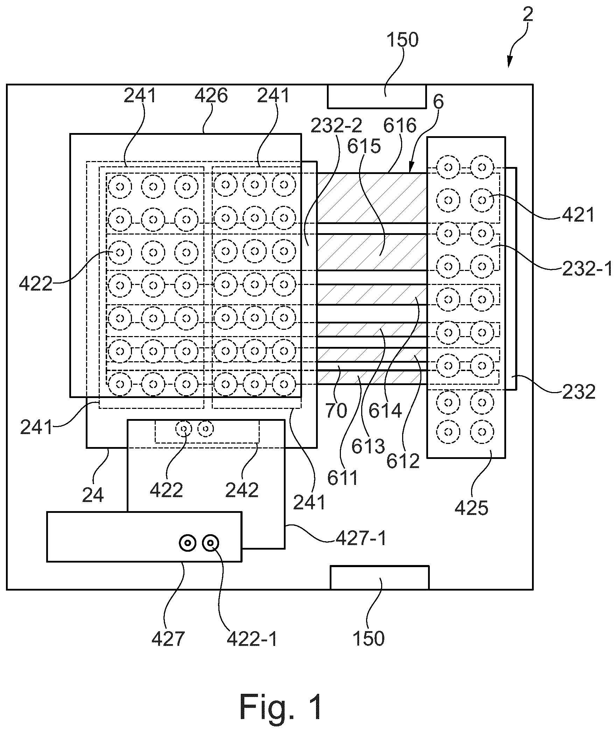

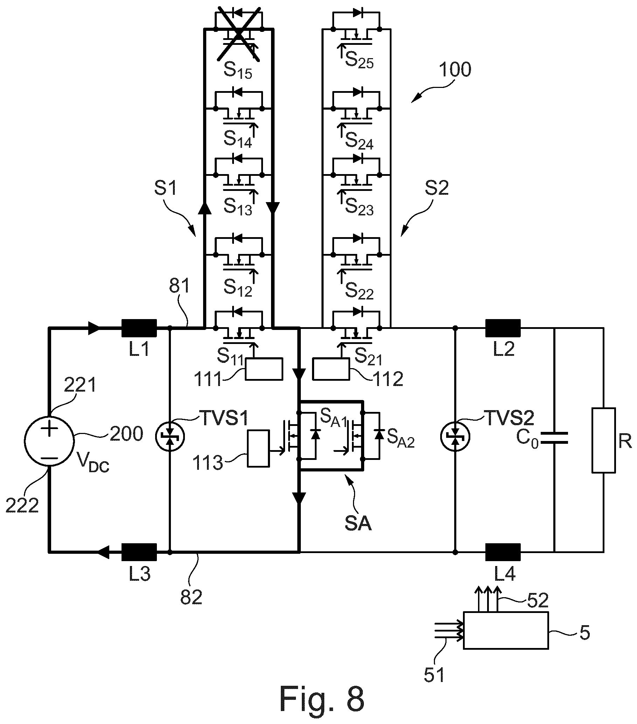

Before discussing embodiments of the present invention with respect to FIGS. 1 to 7, the background of the invention is discussed with respect to FIG. 8 which shows an example environment in which the power modules of the present invention may be implemented.

FIG. 8 depicts a power system that comprises a DC power source 200 having a positive terminal 221 and a negative terminal 222, a power bus having a positive voltage rail 81 and a negative voltage rail 82, a bidirectional solid state power controller (SSPC) 100, a load R, a capacitive load C₀, and several inductances L1-L4, wherein inductances L1, L2 are arranged in the positive voltage rail 81 and inductances L3, L4 are arranged in the negative voltage rail 82.

The SSPC 100 comprises two switching units S1, S2, wherein each of the switching units comprises of a plurality of semiconductor switches S11-S15, S21-S25 which are arranged in parallel. Each of the semiconductor switches S11-S15, S21-S25 comprises a transistor and an antiparallel bypass diode that gives current that flows in the opposite direction a path to flow. The SSPC 100 further comprises two gate drivers 111, 112 for the semiconductor switches S11-S15, S21-S25 of the first and second switching units S1, S2 which control the respective gate voltage. The semiconductor switches S11-S15, S21-S25 may be MOSFET (metal-oxide-semiconductor field-effect transistor), GaN (Gallium Nitride), SiC (Silicon Carbide) or IGBT (Insulated Gate Bipolar Transistor) switches.

By paralleling a plurality of semiconductor switches S11-S15, S21-S25 in the switching units S1, S2, current capacity can be increased and/or voltage drop and power loss can be reduced. However, switching devices may fail due to multiple reasons, such as overvoltage, EMI, high dv/dt, unequal current sharing, manufacturing defects, etc. With a large number of parallel semiconductor switches, there is an increased risk that failure of a single semiconductor switch can lead to failure of the complete SSPC 100 or require shutdown of the complete SSPC 100, this leading to a disruption of the system.

To address this problem, the DC power system of FIG. 1 implements further components which allow to service the DC power system by removing a faulty semiconductor switch without damaging the other semiconductor switches.

To implement such function, the DC power system further comprises an auxiliary switching unit SA which is arranged between the positive voltage rail 81 and the negative voltage rail 82. More particularly, the auxiliary switching unit SA is arranged such that it is connected with one terminal to the negative voltage rail 82 and with another other terminal to the positive voltage rail 81, wherein the connection to the positive voltage rail 81 is such that the connection is at a point between the first and second switching units S1, S2. Thereby, current guided through the auxiliary switching unit SA may be directed either through the switching unit S1 or the switching unit S2.

The depicted embodiment, the auxiliary switching unit SA comprises two parallel semiconductor switches SA1, SA2, but this is to be understood as an example only. Each semiconductor switch SA1, SA2 comprises a transistor (such as MOSFET) and a bypass diode. A gate driver 113 is provided which drives the gates of the semiconductor switches SA1, SA2.

Further, a controller 5 is provided which is depicted schematically. The controller 5 is configured to receive or determine information if one or several of the semiconductor switches S11-S15, S21-S25 has a fault condition through input lines 51. In case a fault condition is detected, the controller 5 is further configured to control the respective switching unit S1, S2 and the auxiliary switching unit SA such that a short-circuit current flows through the auxiliary switching unit SA. It automatically also flows through a faulty semiconductor switch as the semiconductor switches are switched off such that there is current flow through a faulty semiconductor switch only. For example, as indicated in FIG. 9, semiconductor switch S15 of switching unit S1 may have experienced a short-circuit condition. Accordingly, it has to be removed to allow further operation of the SSPC 100. To this end, the auxiliary semiconductor switches SA1 and SA2 are switched ON, thereby providing a short-circuit current between the positive voltage rail 81 and the negative voltage rail 82.

At the same time, in switching unit S1 semiconductor switches S11 to S15 are switched OFF such that the current passes the short-circuited semiconductor switch S15 only. To achieve this, the controller 5 provides respective control signals 52 to the gate driver 111 through output lines 52. Accordingly, the short-circuit current is guided through auxiliary semiconductor switches SA1 and SA2 and the faulty semiconductor switch S15 only. FIG. 9 indicates the direction and path of the short-circuit current. As the short-circuit current is concentrated on the faulty semiconductor switch S15, the faulty semiconductor switch S15 is burned by the short-circuit and, thereby, removed from the switching unit. In particular, a previous short-circuit of the semiconductor switch S15 is transformed by the burning into an open state of the semiconductor switch S15.

When providing for a short-circuit current to remove the faulty semiconductor switch in the above embodiment, the controller 5 controls the auxiliary switching unit SA such that a pre-determined continuous stream of pulses is applied when a fault condition is present. This allows the semiconductor switch to be blown off safely without damaging the auxiliary semiconductor switches SA1, SA2.

Accordingly, a system is described in which a plurality of semiconductor switches are arranged in parallel and in which one or several of the semiconductor switches can be removed when short-circuited by increasing the current through the faulty semiconductor switch. Such removal may be implemented in other circuits as well that comprise switching units with parallel semiconductor switches, such as DC/DC converters or inverters, wherein the current provided to burn a faulty semiconductor switch does not necessarily need to be provided by an auxiliary switching unit SA as depicted in FIG. 8, but may be provided in other manners instead.

There is a desire to be able to effect the removal of a faulty semiconductor switch such as switch S15 in FIG. 8. FIGS. 1 to 6 describe a power module which comprises a semiconductor switch which can be burned in an efficient manner in case of a short-circuit condition of the semiconductor switch.

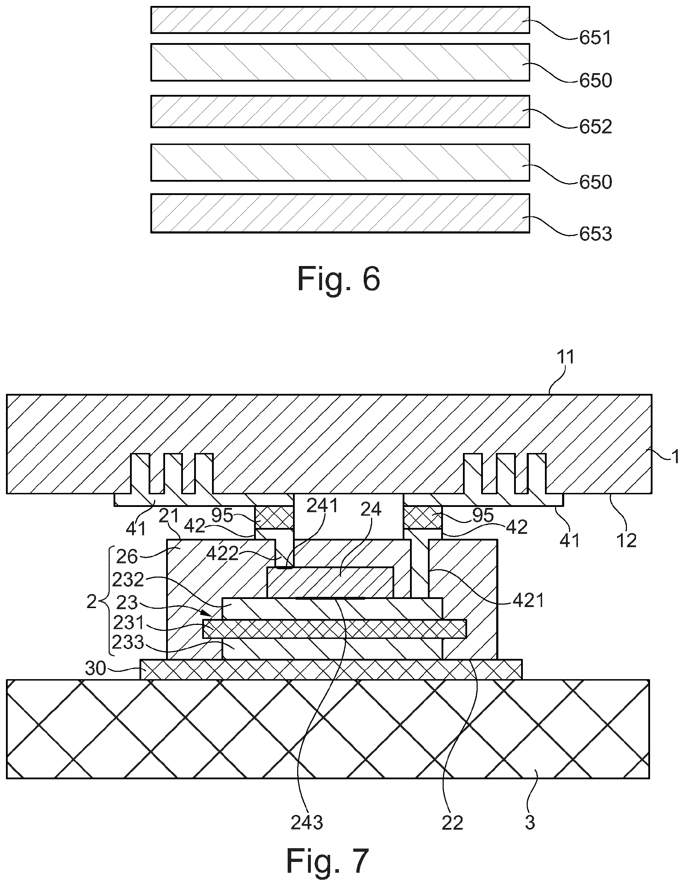

Before discussing the novel and inventive features of such power module, the general construction of a power module is generally described with respect to FIG. 7.

FIG. 7 shows a printed circuit board arrangement 1 which comprises a printed circuit board 1, a power module 2 and a heat sink 3. The printed circuit board 1 is multi-layered and forms, for example, a carrier board on which a large number of power modules 2 and other components are arranged. The printed circuit board 1 has an upper side 11 and a lower side 12. A plurality of electrical contacts 41 are formed on the lower side 12, each of which is subjected to a defined potential, for example a high-voltage potential. The electrical contacts 41 are copper surfaces, for example.

The power module 2 comprises a ceramic circuit carrier 23 and an electrical component in the form of a semiconductor switch 24. The semiconductor switch 24 may be a MOSFET, IGBT, GaN or SiC transistor in embodiments. The semiconductor switch 24 comprises upper electrical contacts, schematically depicted as electrical contact 241, and a lower electrical contact 243. For example, the upper electrical contacts 241 are a source contact and a gate contact, wherein the lower electrical contact 243 is a drain contact.

The ceramic circuit carrier 23 comprises an insulating ceramic layer 231, an upper metallization layer 232 arranged on the upper side of the ceramic layer 231 and an optional lower metallization layer 233 arranged on the lower side of the ceramic layer 231. The metallization layers 232, 233 may be copper layers. The semiconductor switch 24 is arranged with its lower electrical contact 243 on the upper metallization layer 232. The ceramic circuit carrier 23 and the semiconductor switch 24 are arranged in a substrate 26, which defines the outer dimensions of the electrical module 2. The substrate 26 is, for example, a potting material or a printed circuit board material in which the ceramic circuit carrier 23 and the electrical module 24 are embedded.

The upper side 21 of the power module 2 has a plurality of electrical contact pads 42, which are formed, for example, by copper surfaces. The upper side 21 of the power module 2 is soldered to the printed circuit board 2 via surface mounting, whereby the contact pads 42 of the electrical module 2 are electrically connected to the corresponding contact surfaces 41 of the printed circuit board 1 via solder pads 95.

Further, the electrical contact pads 42 are connected to first vias 421 extending from some of the electrical contact pads 42 to the upper metallization layer 232 of the ceramic circuit carrier 23, and second and third vias 422 extending from other of the electrical contact pads 42 to the top surface of the semiconductor switch 24. A bottom side potential and top side potentials of the semiconductor switch 24 are provided via these vias 421, 422. For example, the vias 421 provide for a drain connection and the vias 422 provide for a source connection and a gate connection of the electrical semiconductor switch 24.

In this respect, it is pointed out that there is a plurality of manners of how the electrical contact pads 42 on the upper side 21 of the power module 2 may be connected to the upper electrical contacts 241 of the semiconductor switch. For example, in other embodiments, there may be a arranged a circuit board between the contact pads 42 and the upper electrical contacts 241 (instead of using vias 422). In another example, the upper electrical contacts 241 may be identical with some of the contact pads 42 (in such case the upper side of the semiconductor switch 24 forms part of the upper side of the power module 2). In such alternative embodiments, however, vias 21 to the upper metallization layer 232 are still present.

The underside of the electrical module 2, which is formed by the lower metallization layer 233, is thermally coupled to the heat sink 3 via a thermal interface material 30, for example a heat conducting mat. The ceramic circuit carrier 23 with the ceramic layer 231 serves on the one hand to electrically insulate the semiconductor switch 24 arranged on the ceramic circuit carrier 23 from the heat sink 3 and at the same time provides a thermal connection to the heat sink 3.

Accordingly, with the power module of FIG. 7, the upper electrical contacts 241 of the semiconductor switch 24 are electrically contacted through contacts 41 of the printed circuit board, contact pads 42 on the upper side of the power module 2, and vias 422. The lower electrical contact 243 of the semiconductor switch 24 is electrically contacted through contacts 41 of the printed circuit board, a contact 42 on the upper side of the power module 2, vias 421, and the upper metallization layer 232. The upper metallization layer 232 realizes a conductive plane for contacting the lower electrical contact 243.

In this respect, it is pointed out that the vias 421 are arranged at some distance from the semiconductor switch 24 to maintain the required creepage and clearance distance.

FIG. 1 shows a first embodiment of a power module 2, wherein a top view is depicted. The top view is translucent in that not only the top layer is depicted, but also layers below the top layer. The general design is the same as discussed with respect to FIG. 7. A semiconductor switch 24 formed by a die comprises upper electrical contacts 241, 242 which are arranged on the upper side of the semiconductor switch 24. More particularly, two source contacts 241 and one gate contact 242 are provided on the upper side of the semiconductor switch 24. The source contacts 241 are connected through vias 42 with an upper contact pad 426, in the same manner as depicted in FIG. 7. The gate contact 242 is connected through vias 422, an intermediate conductive plane 427-1 and further vias 422-1 with an upper contact pad 427, wherein this is to be understood as an example only.

FIG. 1 further shows an upper metallization layer 232 which is arranged on an insulating layer such as a ceramic layer as shown in FIG. 7 (but not to be seen in the top view of FIG. 1). A further upper contact pad 425 is arranged on the upper side of the power module 2. The further contact pad 425 is connected by means of vias 421 (see also FIG. 7) to the upper metallization layer 232. Accordingly, the upper side of the power module comprises an electrical contact pad 425 for a drain voltage, an electrical contact pad 426 for a source voltage, and an electrical contact pad 427 a gate voltage, wherein the respective contact pads 425 to 427 are connected through vias 421, 422 and an upper metallization layer 232 in the case of vias 421 with respective upper and lower electrical contacts 241, 242 of the semiconductor switch 24, wherein the lower electrical contact (see lower electrical contact 243 in FIG. 7) is not to be seen in the top view of FIG. 1. This lower electrical contact, which is a drain contact, is contacted through the upper metallization layer 232, wherein the upper metallization layer 232 forms a conduction path 6 between an area 232-1 of the upper metallization layer 232 connected to the vias 421 and an area 232-2 of the upper metallization layer 232 connected to the lower electrical drain contact (contact 243 in FIG. 7).

According to FIG. 1, the conduction path 6 is not formed by an uninterrupted metallization, but is broken into a plurality of separate segments 611-616 formed as strips, wherein the strips 611-616 are separated by slits 70. Each of the strips 611-616 is formed by a rectangular, metallized area (such as a copper area), wherein the width of the strips increases from a first edge-located strip 611 to a second edge-located strip 616.

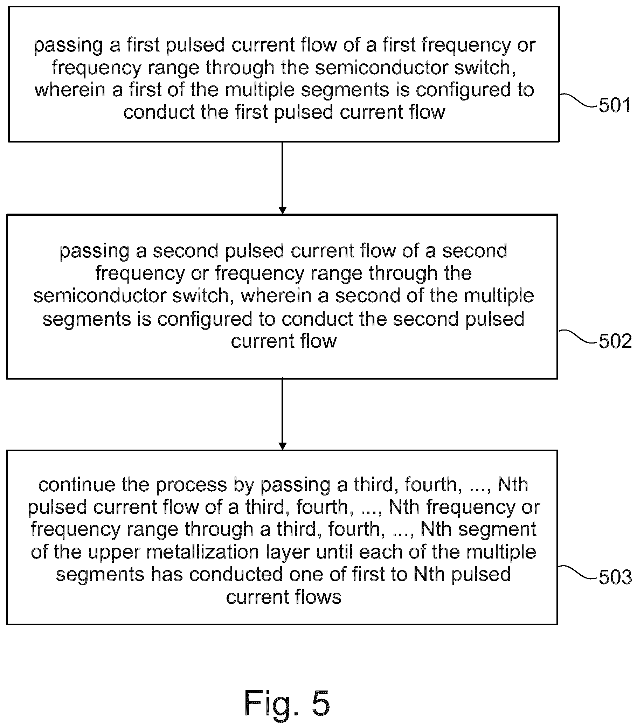

Each of the segments/strips 611-616 is configured to conduct a pulsed current of a specific frequency or frequency range. Such pulsed current may be effected by a controller which applies a pulsed voltage to the gate contact of the semiconductor switch 24 (such as controller 5 in FIG. 8). Accordingly, depending on the applied frequency or frequency range, a specific one of the strips 611-616 primarily guides the current through the semiconductor switch 24. In case of a short-circuited semiconductor switch 24, this allows to concentrate the short-circuit current to one of the strips 611-616 to burn that strip in a controlled manner, as will be discussed in more detail with respect to FIG. 5.

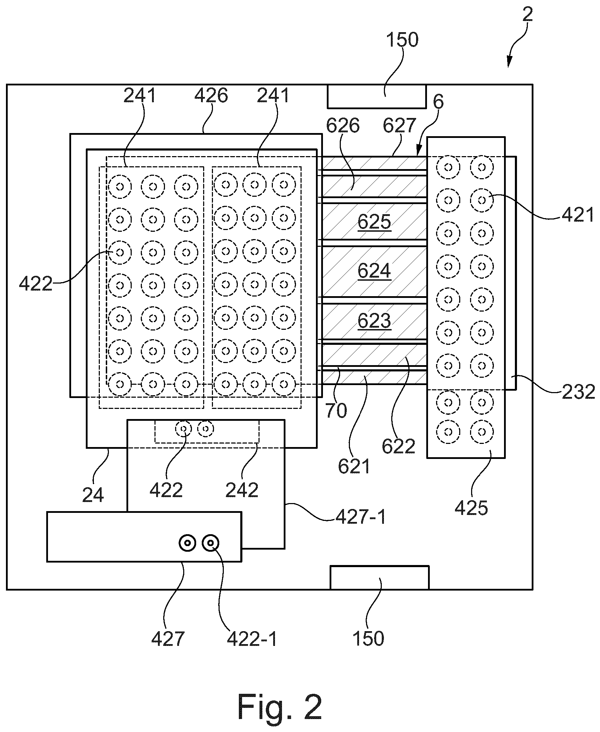

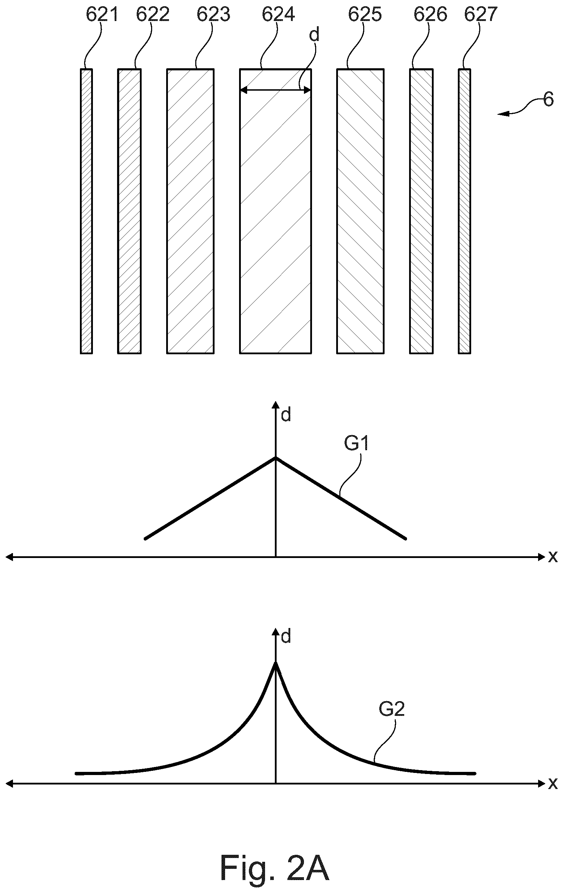

The embodiment of FIG. 2 is similar to the embodiment of FIG. 1 except that the conduction path 6 is broken into a plurality of separate strips 621-627 that differ in width in a manner that the width of the strips increases from first and second edge-located strips 621, 627 towards a middle strip 624 which has the largest width. As in FIG. 1, the strips 621-627 are formed as a straight rectangular segments separated by slits 70.

Generally, the slits 70 may have the same width or differing widths.

FIG. 2A shows schematically a plurality of separate strips/segments 621-627 which form a conduction path 6, wherein the width d of the segments 621-627 increases towards a middle segment 624 similar as in FIG. 2. The segment width d may follow a linear or exponential pattern as shown in the upper and lower function graphs G1 and G2 in FIG. 2A, wherein the width d changes dependent on the position x of the segments in a linear or exponential manner.

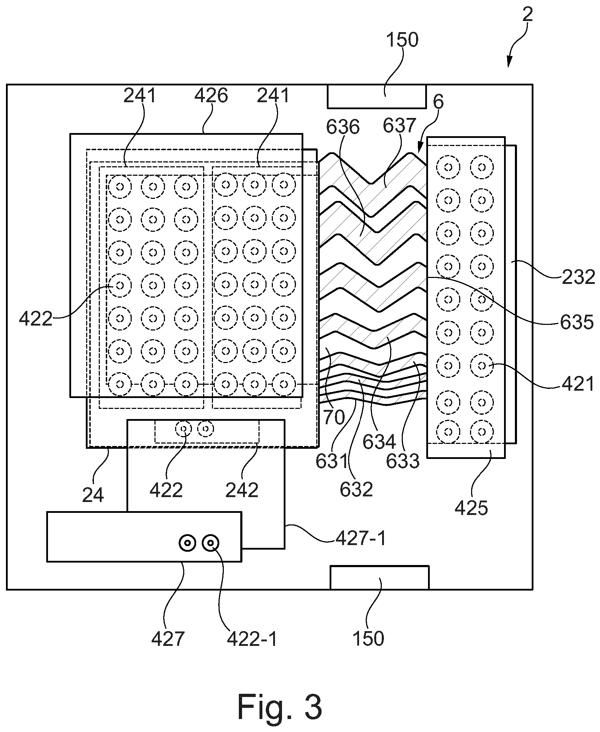

In FIG. 3, the conduction path 6 is provided by separate strips 631-637 in zigzag form as one example of a non-rectangular form. As in FIG. 1, the width of the strips increases from a first edge-located strip 631 to a second edge-located strip 637. Also, the amplitude of the zigzag curve increases. As in the other embodiments, each of the segments/strips 631-637 is configured to conduct a pulsed current of a specific frequency or frequency range.

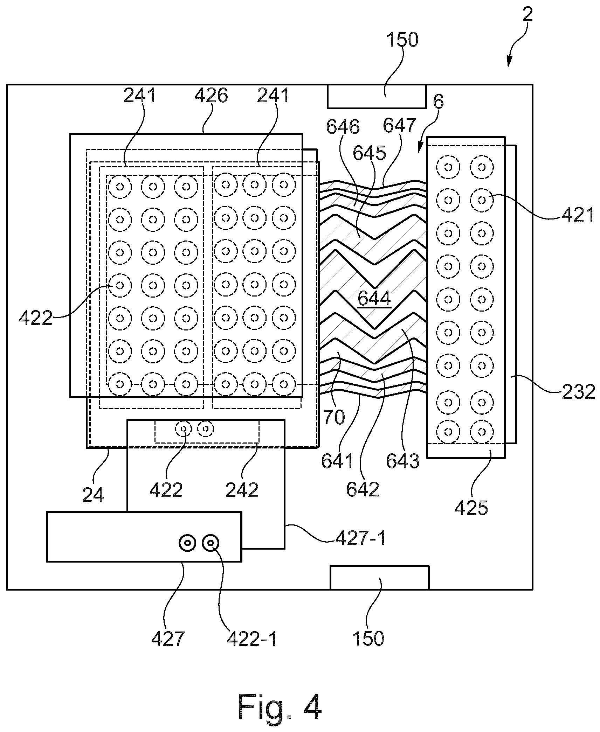

The embodiment of FIG. 4 is similar to the embodiment of FIG. 3 except that the conduction path 6 is broken into a plurality of separate strips 641-647 that differ in width such that the width of the strips increases from first and second edge-located strips 641, 647 towards a middle strip 644 which has the largest width. As in FIGS. 1 to 3, the strips 641-647 are by slits 70.

In other embodiments, the separate strips may be formed in different ways, such as having a wavy such as a sine curve form.

In the embodiments of FIGS. 1 to 4, there may be further provided a vent 150 which serves to transport thermal heat away from the power module, in particular after overheating in case of a short-circuit condition.

FIG. 5 is a flowchart of the steps of a method to operate a power module such as power modules shown in FIGS. 1 to 4. According to step 501, a first pulsed current flow of a first frequency or frequency range is passed through the semiconductor switch, wherein a first of the multiple segments is configured to conduct the first pulsed current flow. The first pulsed current flow may be provided by switching other switches respectively. For example, in the embodiment of FIG. 8, the gate signal applied to the auxiliary semiconductor switches SA1, SA2 may be of the first frequency or frequency range. Accordingly, the semiconductor switches SA1, SA2 are turned on in accordance with the first frequency or frequency range. It follows that a short-circuit current pulsed in accordance with the first frequency or frequency range is guided through the faulty semiconductor switch (through S15 in FIG. 8, and not through S11 to S14 as they are not faulty) and the auxiliary semiconductor switches SA1 and SA2.

The first pulsed control signal is of a specific first frequency or of a specific first frequency range. A frequency range is considered, e.g., if the frequency of the pulsed control signal is linearly increased such as with a frequency sweep. In such case, a particular interval of the frequency, which is referred to as first frequency range, is associated with the first pulsed control signal.

Accordingly, a pulsed current flow of the first frequency or frequency range passes through the semiconductor switch. At the same time, a first of the multiple segments formed by the upper metallization layer is configured to mainly conduct the first pulsed current. In other words, the dimensions of the first segment are such that the pulsed current of the first frequency or frequency range is concentrated in the first segment. This means that, if the semiconductor switch is short-circuited, the short-circuit current is concentrated to the first segment, thereby increasing the temperature of and burning the first segment.

Subsequently, in step 502, a second pulsed current flow of a second frequency or frequency range passes through the semiconductor switch, wherein a second of the multiple segments is configured to conduct the second pulsed current flow. Accordingly, a pulsed current flow of the second frequency or frequency range passes through the semiconductor switch. At the same time, a second of the multiple segments formed by the upper metallization layer is configured to mainly conduct the second pulsed current. Accordingly, the dimensions of the second segment are such that the pulsed current of the second frequency or frequency range is concentrated in the second segment. This means that, if the semiconductor switch is short-circuited, the short-circuit current is concentrated to the second segment, thereby increasing the temperature of and burning the second segment.

According to step 503, such a process may be continued by passing a third, fourth, ..., Nth pulsed current flow of a third, fourth, ..., Nth frequency or frequency range through the semiconductor switch, namely, a third, fourth, ..., Nth segment of the upper metallization layer until each of the multiple segments has conducted one of first to Nth pulsed current flows, thereby being burned in case of a short-circuit condition.

In this manner, the individual segments of the multiple separate segments of the upper metallization layer can it be burned one by one as the frequency sweeps between a minimum and a maximum, thereby avoiding massive burning and heat development of the semiconductor switch at a specific time, and rather provide for a controlled burning of the semiconductor switch. The short-circuited semiconductor switch is transformed in this manner from a short-circuit condition to an open-circuit condition and thereby removed.

FIG. 6 depicts an alternative embodiment of the conduction path 6 in which the separate segments are not formed by strips separated by slits, but are provided in a stacked manner. According to FIG. 6, the metallization layer is formed by a plurality of stacked conductive layers 651, 652, 653 (such as copper layers), wherein non-conductive layers 650 are arranged between the conductive layers. The conductive layers may be ceramic layers or FR4 layers. The conductive layers comprises an upper conductive layer 651 and a lower conductive layers 653, wherein the thickness of the conductive layers is increased towards the lower conductive layer 653. There may further be provided vias (not shown) interconnecting the conductive layers 651, 652, 653. For example, vias 421 of FIG. 1 may interconnect such conductive layers. Further vias may be provided at the end of the conductive layers 651, 652, 653 connected to the lower electrical contact of the semiconductor switch 24.

By providing layers 651, 652, 653 of different thickness, the pulsed current guided through the semiconductor switch and in particular the conduction path 6 automatically spreads out to the conductive layers which have a thickness that corresponds with the respective frequency. Again, the single layers 651, 652, 653 may be burned sequentially in the course of a frequency sweep.

Regarding the width of the slits/segments, the following may apply for all of the above described embodiments. The individual segments serve as fuse-able conduction path when joule loss density is high, and therefore the sizing of the segment width is dominated by thermal design aspects. The design process may involve an electro-thermal finite-element analysis or design-of-experiments to fine-tune the segment width, or a design may be chosen in accordance with FIG. 2A.

In embodiments, the thinnest segment width may be determined mainly by the manufacturing technology. It may be as low as 6 mil (1 mil = 25.4 µm). With an example width of 6 mil as the out-most segment, the effective frequency to have the current crowding effects may be in the range of 1-30 MHz for that segment, corresponding to a rise or fall time of 0.3 - 1 µs. In view of such frequency range, the normal operating frequency which is in the kilo-hertz range (which is present during normal operations of the circuit, such as DC conduction or 50 Hz AC conduction) will not incur any current crowding effects. Accordingly, in such embodiment, only high magnitude fault currents occurring in the microseconds range will lead to current crowding effects and therefore fusing actions in the segments.

It should be understood that the above description is intended for illustrative purposes only, and is not intended to limit the scope of the present disclosure in any way. Also, those skilled in the art will appreciate that other aspects of the disclosure can be obtained from a study of the drawings, the disclosure and the appended claims. All methods described herein can be performed in any suitable order unless otherwise indicated herein or otherwise clearly contradicted by context. Various features of the various embodiments disclosed herein can be combined in different combinations to create new embodiments within the scope of the present disclosure. In particular, the disclosure extends to and includes all combinations and sub-combinations of one or more features described herein. Any ranges given herein include any and all specific values within the range and any and all sub-ranges within the given range.

## Claims

1. A power module (2) comprising:
an upper side (21) and a lower side (22);
a plurality of electrical contact pads (42) on the upper side (21) which are configured to electrically contact corresponding contact pads (41) of a printed circuit board (1);
an insulating layer (231);
an upper metallization layer (232) disposed on the insulating layer (231); and
a semiconductor switch (24) having upper electrical contacts (241, 242) and a lower electrical contact (243), wherein the semiconductor switch (42) is arranged on the upper metallisation layer (232), and wherein the lower electrical contact (243) is electrically connected to the upper metallization layer (232);
wherein the plurality of electrical contact pads (42) comprises a first contact pad (425) which is electrically connected via first vias (421) to the upper metallization layer (232) and second and third contact pads (426, 427) which are connected to the upper electrical contacts (241, 242) of the semiconductor switch (24);
the upper metallization layer (232) is configured to provide a conduction path (6) between the first vias (421) and the lower electrical contact (243) of the semiconductor switch (24); and
the upper metallisation layer (232) is structured to form multiple separate segments (611-616; 621-627; 631-637; 641-647; 651-653), wherein each segment (611-616; 621-627; 631-637; 641-647; 651-653) is configured to form part of the conduction path (6) between the first vias (421) and the lower electrical contact (243) of the semiconductor switch (24).

2. The power module of claim 1, wherein each of the different segments (611-616; 621-627; 631-637; 641-647; 651-653) of the upper metallization layer (232) is configured to conduct a pulsed current of a different specific frequency or frequency range.

3. The power module of claim 1 or 2, wherein the multiple segments (611-616; 621-627; 631-637; 641-647) are provided in the form of multiple strips of different size and/or form, wherein the multiple strips form the conduction path (6).

4. The power module of claim 3, wherein the multiple strips (611-616; 621-627; 631-637; 641-647) are formed by slits (70) provided in the upper metallization layer (232).

5. The power module of claim 3 or 4, wherein the strips comprise first and second edge-located strips (611, 616; 631, 637), wherein the width of the strips (611-616; 631-637) increases from the first edge-located strip (611, 631) to the second edge-located strip (616, 637).

6. The power module of claim 3 or 4, wherein the strips comprise first and second edge-located strips (621, 627; 641, 647), wherein the width of the strips (621-627; 641-647) increases from the first and second edge-located strips (621, 627; 641, 647) to a middle strip (624, 644) arranged between the first and second edge-located strips.

7. The power module of any one of claims 3 to 6, wherein the strips (611-616; 621-627) are formed as a straight rectangular segments or as zigzag or wavy formed segments.

8. The power module of claim 1 or 2, wherein the multiple segments are provided in the form of multiple stacked conductive layers (651-653) of different thickness, wherein non-conductive layers (650) are arranged between the conductive layers (651-653), and wherein the multiple conductive layers (651-653) of different thickness form the conduction path (6).

9. The power module of any preceding claim, wherein:
the first contact pad (425) is a drain pad configured to provide a drain voltage to the semiconductor switch (24);
the second contact pad (426) is a source pad configured to provide a source voltage to the semiconductor switch (24);
the third contact pad is a gate pad (427) configured to provide a gate voltage to the semiconductor switch (24);
the semiconductor switch (24) comprises as upper electrical contacts a source contact (241) and a gate contact (242); and
the semiconductor switch (24) comprises as a lower electrical contact a drain contact (243).

10. The power module of claim 9, wherein the multiple segments (611-616; 621-627; 631-637; 641-647; 651-653) are configured to connect an area (232-1) of the upper metallization layer (232) connected to the first vias (421) and an area (232-2) of the upper metallization layer (232) connected to the lower electrical drain contact (243).

11. The power module of any preceding claim, wherein a vent (150) is integrated into the module (2), and the vent (150) is configured to improve the removal of thermal energy from the power module (2) in case of a short-circuit of the semiconductor switch (24).

12. A method of operating the power module (2) of any preceding claim, the method comprising the steps of:
passing (501) a first pulsed current flow of a first frequency or frequency range through the semiconductor switch (24), wherein a first of the multiple segments (611-616; 621-627; 631-637; 641-647; 651-653) is configured to conduct the first pulsed current flow; and
passing (502) a second pulsed current flow of a second frequency or frequency range through the semiconductor switch (24), wherein a second of the multiple segments (611-616; 621-627; 631-637; 641-647; 651-653) is configured to conduct the second pulsed current flow.

13. The method of claim 12, wherein the method is continued (503) by passing a third, fourth, ..., Nth pulsed current flow of a third, fourth, ..., Nth frequency or frequency range through the semiconductor switch (24), until each of the multiple segments (611-616; 621-627; 631-637; 641-647; 651-653) has conducted one of first to Nth pulsed current flows.

14. The method of claim 12 or 13, wherein each of the multiple segments (611-616; 621-627; 631-637; 641-647; 651-653) is configured to burn when conducting a current in accordance with the corresponding pulsed current flow.

15. The method of any one of claims 12 to 14, wherein the multiple segments (611-616; 621-627; 631-637; 641-647; 651-653) are configured to burn one after the other when the pulsed current sweeps through the first to Nth frequencies or frequency ranges.
